# FASCICULE DE BREVET EUROPEEN

(11) **EP 2 045 354 B1**
(45) Date de publication et mention de la délivrance du brevet: **23.02.2011**
(21) Numéro de dépôt: 08165846.0
(22) Date de dépôt: 03.10.2008
(51) Int. Cl.: C23C 16/12, F01D 9/02

(54) **Procédé d'aluminisation en phase vapeur de pièces métalliques creuses de turbomachine**
Aluminisierungsverfahren in der Dampfphase von hohlen Metallteilen eines Turbotriebwerks
Method for aluminising the hollow metal parts of a turbomachine in vapour phase

(30) Priorité: 03.10.2007 FR 0706935
(43) Date de publication de la demande: 08.04.2009
(73) Titulaire: SNECMA, 75015 Paris (FR)
(72) Inventeur: Carlin, Maxime, 75018 PARIS (FR); Lanciaux, Lucie, 75017 PARIS (FR); Le Henanff, Philippe, 93150 BLANC MESNIL (FR)
(74) Mandataire: David, Daniel

(56) Documents cités:
- EP-A- 1 577 415
- FR-A- 2 830 874
- US-A- 5 334 417

## Description

La présente invention concerne le dépôt d'un revêtement d'aluminium sur une pièce métallique, notamment sur une pièce métallique creuse comprenant une cavité avec une ouverture permettant un accès à cette cavité. Elle vise plus particulièrement l'application d'un tel revêtement sur des aubes creuses de turbomachine incorporant une chemise de distribution de fluide de refroidissement.

Un moteur à turbine à gaz, tel qu'utilisé pour la propulsion dans le domaine aéronautique comprend une entrée d'air atmosphérique qui communique avec un ou plusieurs compresseurs, dont une soufflante généralement, entraînés en rotation autour d'un même axe. Le flux primaire de cet air après avoir été comprimé alimente une chambre de combustion disposée annulairement autour de cet axe et est mélangé à un carburant pour fournir des gaz chauds en aval à une ou plusieurs turbines à travers lesquelles ceux-ci sont détendus, les rotors de turbine entraînant les rotors de compression. Les moteurs fonctionnent à une température des gaz moteurs en entrée de turbine que l'on cherche aussi élevée que possible car les performances lui sont liées. Dans ce but les matériaux sont sélectionnés pour résister à ces conditions de fonctionnement et les parois des pièces balayées par les gaz chauds, telles que les distributeurs ou les ailettes mobiles de turbine, sont pourvues de moyens de refroidissement. Par ailleurs, en raison de leur constitution métallique en superalliage à base de nickel ou de cobalt, il est nécessaire aussi de prémunir celles-ci de l'érosion et de la corrosion engendrées par les constituants des gaz moteurs à ces températures.

Un moyen connu pour assurer la protection de ces pièces est de déposer un revêtement à base d'aluminium sur les surfaces susceptibles d'agression par les gaz. L'aluminium se fixe au substrat par inter-diffusion métallique et forme une couche protectrice d'oxyde en surface. L'épaisseur de la couche protectrice est de l'ordre de quelques dizaines de microns.

La présente invention se rapporte à la technique, en soi connue, de dépôt de l'aluminium en phase vapeur ou encore désignée aluminisation par dépôt en phase vapeur. Selon le procédé, on dispose les pièces à traiter dans une enceinte dans laquelle l'atmosphère est constituée d'un mélange d'un gaz inerte ou réducteur, par exemple argon ou hydrogène, et d'un gaz actif comprenant un halogénure d'aluminium. A la température de réaction, entre 900°C et 1150°C, l'halogénure se décompose à la surface de la pièce en halogène gazeux et en aluminium qui diffuse dans le métal.

On produit l'halogénure en disposant dans l'enceinte avec les pièces à traiter, des blocs de métal aluminium ou d'alliage d'aluminium qui forment le donneur, en présence de granules d'un composé d'halogène, chlore ou fluor, qui forment l'activateur. On fait circuler le gaz inerte sur l'activateur à une température permettant la sublimation de l'halogène qui est entraîné sur le donneur et avec lequel il réagit pour produire l'halogénure métallique qui, à cette température, est sous forme vapeur. L'halogénure se décompose ensuite au contact du substrat métallique à revêtir permettant le dépôt de l'aluminium ; l'halogène gazeux est reformé.

Lorsque les pièces statoriques aussi bien que mobiles sont pourvues de cavités internes parcourues par un fluide de refroidissement, de l'air prélevé au compresseur, on a constaté que les parois de ces cavités étaient également sujettes à corrosion. Des retours de pièces utilisées sur des moteurs travaillant dans certains environnements ont montré une attaque de ces surfaces. On a relevé, par exemple, une corrosion interne des distributeurs, des libérations de plaques de corrosion dans la cavité des distributeurs, le bouchage des trous d'évents de bord de fuite, etc. Une protection pour ces parties de pièces est donc également nécessaire.

Le mode d'aluminisation par dépôt en phase vapeur convient bien a priori pour appliquer un revêtement de protection car le gaz porteur et les composants actifs sont susceptibles de pénétrer dans les passages étroits de circulation du fluide de refroidissement dans la mesure où ces passages sont ouverts. La réalité montre que ce n'est pas le cas. L'épaisseur de la couche de protection n'est pas uniforme ; elle diminue fortement à partir des orifices d'accès des cavités. Par ailleurs des accumulations se forment au niveau des trous d'évent des cavités réduisant la section de passage et les propriétés de refroidissement de la pièce.

Dans la demande de brevet FR 2830874 au nom de la demanderesse on décrit un procédé d'aluminisation par dépôt en phase vapeur de pièces de turbomachines métalliques pourvues de trous et de cavités communiquant avec l'extérieur selon lequel un précurseur gazeux du dépôt à réaliser comprenant un composé de l'aluminium est amené avec l'aide d'un gaz porteur au contact des surfaces de la pièce disposée dans une enceinte, le gaz porteur est soi l'hélium soit l'argon et la pression dans l'enceinte est choisie de manière que le libre parcours moyen des molécules du gaz porteur est deux fois supérieur à celui des molécules d'argon sous pression atmosphérique. Le libre parcours moyen des molécules est usuellement défini comme le rapport 1/P*D² où P est la pression régnant dans l'enceinte et D le diamètre moléculaire.

Par l'allongement du libre parcours moyen des molécules du gaz porteur, la diffusion de l'halogénure dans les canaux internes est accrue et l'épaisseur du dépôt dans les zones moins accessibles par la méthode classique est augmentée ; la protection globale en est améliorée. L'augmentation du libre parcours résulte soit du choix du gaz porteur, là l'hélium, soit d'une diminution de la pression comme on peut le déduire de la formule ci-dessus.

L'invention a pour objet une variante de procédé permettant d'obtenir un revêtement des parois des cavités internes sur toute la surface avec une épaisseur suffisante.

L'invention concerne les pièces creuses avec une cavité et une ouverture au moins par laquelle la cavité communique et est accessible depuis l'extérieur. Elle concerne plus particulièrement de telles pièces, pourvues d'une chemise interne à l'intérieur de la cavité, rapportée à travers l'ouverture et assemblée avec la pièce.

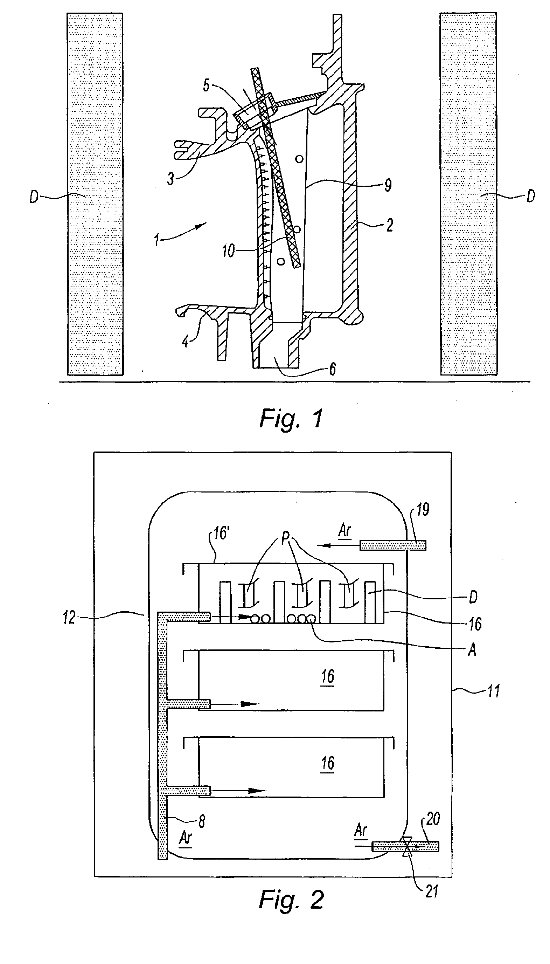

Une telle pièce est représentée sur la figure 1. Il s'agit de la coupe d'un distributeur d'un étage à basse pression dans un moteur à turbine à gaz à double corps. L'aube 1 de distributeur comprend une partie fabriquée par coulée de métal dans un moule carapace. Cette partie, hachurée sur la figure, est formée d'une pale 2 creuse entre deux plateformes 3 et 4. La cavité de la pale 2 communique par ses deux extrémités, respectivement d'un côté avec une ouverture 5 d'alimentation en fluide de refroidissement et de l'autre côté avec une sortie de fluide 6. A l'intérieur de la cavité de la pale 2, est disposée une chemise 9 de forme sensiblement cylindrique. La chemise est soudée ou brasée du côté de l'ouverture 5 d'alimentation en air de refroidissement par une soudure/brasure périphérique le long du bord de l'ouverture de la cavité. L'autre extrémité de la chemise est engagée dans un logement cylindrique communiquant avec la sortie 6, sans y être soudée pour permettre la dilatation relative de la chemise par rapport à la pale pendant les étapes de fonctionnement transitoires. La chemise est perforée sur sa longueur et ménage un espace avec la paroi de la pale de telle façon que l'air de refroidissement provenant de l'ouverture 5 d'alimentation en air passe pour partie à travers les perforations de la chemise et forme une pluralité de jets d'air refroidissant la paroi de la pale par impact et convection. Cet air est ensuite évacué par des évents ménagés à proximité du bord de fuite de la pale. L'air qui n'a pas traversé la paroi de la chemise est guidé vers l'ouverture 6 pour être conduit vers d'autres parties de la machine.

En fabrication, la chemise 9, réalisée séparément de la pale, est rapportée dans la pale en étant glissée à travers l'orifice 5 puis brasée à proximité de l'embouchure comme mentionné plus haut. La partie inférieure, sur la figure, reste libre de se dilater et de coulisser dans le logement formé par l'ouverture 6.

Conformément à l'invention, on améliore sensiblement le dépôt d'aluminure à l'intérieur de la cavité avec le procédé suivant, applicable à toute pièce comportant une cavité accessible depuis l'extérieur :

Le procédé d'aluminisation par dépôt en phase vapeur pour la protection contre l'oxydation à haute température d'une pièce métallique de turbomachine,

Ladite pièce comportant une cavité et une ouverture accessible depuis l'extérieur,

Procédé selon lequel un halogénure est formé par réaction entre un halogène et un donneur métallique contenant de l'aluminium, puis l'halogénure est transporté par un gaz porteur pour venir au contact de ladite pièce métallique,

Ledit donneur métallique étant disposé au moins en partie dans ladite cavité,

Est caractérisé par le fait que le donneur métallique se présente sous la forme d'un bâtonnet obtenu par frittage à chaud sous pression d'un mélange de poudre métallique.

Le métal composant le bâtonnet comprend l'aluminium, de préférence en combinaison avec l'un des métaux Cr, Ni, Co ou Fe. L'aluminium est en proportion comprise entre 30 et 80 % atomique dans le bâtonnet, plus particulièrement en proportion comprise entre 45 et 70% atomique.

En apportant un donneur à l'intérieur de la cavité, constitué par le bâtonnet, on permet un dépôt efficace. On résout notamment le problème d'accessibilité depuis l'extérieur de la pièce tout en maîtrisant la quantité de donneur interne par la longueur du bâtonnet par exemple.

Plus particulièrement le bâtonnet comprend également au moins un élément d'amélioration de la tenue à l'oxydation compris dans le groupe suivant (Hf, Y, Zr, Si, Ti, Ta, Pt, Pd, Ir).

Le procédé s'applique aux pièces en superalliage à base nickel ou cobalt telles qu'une aube de distributeur avec une cavité intérieure de distribution de fluide de refroidissement. Dans ce cas, le bâtonnet est introduit par l'ouverture d'amenée de fluide de refroidissement.

On connaît le document EP1577415 qui porte sur un procédé d'aluminisation en phase vapeur de pièces de turbomachine telles que des aubes mobiles creuses de turbine selon lequel on dispose à l'intérieur de la pièce des bandes composées de 85% en poids de poudre à base d'aluminium, le reste étant formé d'un liant organique avec éventuellement un activateur. Le liant organique est carbonisé pendant le traitement et la partie de la bande qui n'a pas été consommée peut être extraite aisément de la cavité. Une telle bande est déjà connue en soi et décrite dans le document US5334417. La solution de l'invention permet une manipulation aisée du bâtonnet, avec comme avantage, en raison de l'emploi d'un matériau purement métallique, d'une absence de résidu organique. Il n'y a donc pas de pollution. Par ailleurs le bâtonnet pouvant être usiné selon les formes voulues permet une utilisation simplifiée pour l'utilisateur.

Enfin le bâtonnet ne nécessite pas d'opération spécifique de retrait, les résidus étant éliminés dans les opérations de nettoyage habituelles.

On décrit maintenant un mode de réalisation, non limitatif, de l'invention en référence aux dessins sur lesquels :
La figure 1 représente une aube de distributeur avec cavité interne et chemise de distribution d'air de refroidissement rapportée dans cette cavité, un bâtonnet étant logé dans ladite chemise.
La figure 2 montre une installation d'aluminisation convenant pour la mise en oeuvre du procédé de l'invention.
La figure 3 est un graphique montrant la variation de l'épaisseur de la couche déposée sur les parois de cavités internes d'ailettes fixes selon une technique de l'art antérieur et la technique de l'invention.

La figure 2 montre très schématiquement une installation conventionnelle d'aluminisation par dépôt en phase vapeur dans laquelle on met en oeuvre le procédé de l'invention.

Une enceinte 12 est montée à l'intérieur d'un four 4 capable de chauffer les pièces à une température de 1200°C. Dans cette enceinte sont disposées des boîtes 16, ici trois superposées, avec un couvercle 16'. Ces boîtes contiennent les pièces à traiter P, par exemple des distributeurs de turbine, avec le donneur D métallique sous forme de poudre ou de blocs et l'activateur A, par exemple NH₄F ou NH₄Cl. L'enceinte 12 comprend ici une alimentation 18 en gaz porteur de purge, une alimentation 19 en gaz porteur de balayage et une évacuation 20 commandée par une vanne 21. Cette fonction de balayage est toutefois facultative dans les installations courantes.

Après avoir disposé les pièces, le donneur et l'activateur dans les boîtes 16, on commence par purger l'enceinte 12 en introduisant le gaz porteur, argon par exemple par la conduite 18. On interrompt l'alimentation quand l'air de l'enceinte a été remplacé par l'argon. On actionne ensuite le chauffage du four tout en alimentant l'enceinte en argon par la conduite 19. L'excès de gaz est évacué par le conduit 20. À la température d'activation de l'activateur A, l'halogène, chlore ou fluor, est libéré. En venant au contact du donneur l'halogène réagit avec le métal et forme un halogénure. La vapeur d'halogénure ainsi formée circule à l'intérieur des boîtes 16 et vient au contact des pièces métalliques P. A ce moment l'halogénure se décompose et libère le métal qui se dépose sur la pièce.

L'argon est introduit en permanence par la conduite 19 dans l'enceinte 12 et est évacué par le conduit 20. La durée du traitement est comprise entre 2 et 6 heures.

Conformément à l'invention, on rapproche le donneur de la cavité en utilisant un bâtonnet donneur 10.

Avant de commencer le traitement, on introduit le bâtonnet donneur 10 par l'ouverture 5.

Le bâtonnet a été fabriqué selon la technologie de la métallurgie des poudres.

La technique consiste à mélanger les constituants sous forme de poudre métallique puis à consolider par frittage sous pression le mélange ainsi préparé. Comme cela est connu le frittage est un processus faisant évoluer par traitement thermique le mélange aggloméré de particules individuelles sous l'effet de la pression considérée. Ce procédé permet de faire réagir intégralement ou partiellement les composants pour former des intermétalliques qui serviront de donneur. De la sorte on obtient un bloc solide dont la porosité est plus faible que la porosité initiale. Ce processus se caractérise aussi par le maintien d'au moins une phase solide intermétallique telle qu'un aluminure de chrome pendant tout le traitement thermique, et la conservation d'une certaine stabilité de forme et de dimension.

Après l'opération de frittage le bâtonnet peut être usiné pour que sa forme soit adaptée à l'espace disponible pour son introduction dans la cavité.

L'avantage de cette solution par rapport à une autre solution qui consisterait à disposer un panier donneur à l'intérieur de la cavité, est de permettre le traitement de la pièce déjà assemblée. L'emploi d'un panier dans une étape intermédiaire obligerait à traiter la pièce sans la chemise puis à monter la chemise sur la pièce dont les parois sont revêtues d'une couche d'aluminium ce qui nécessite une adaptation particulière des moyens de brasage.

Par ailleurs il n'est pas nécessaire de nettoyer l'intérieur de la cavité de résidus de donneur selon un procédé spécifique. Les résidus sont éliminés par les opérations classiques de nettoyage déjà prévus.

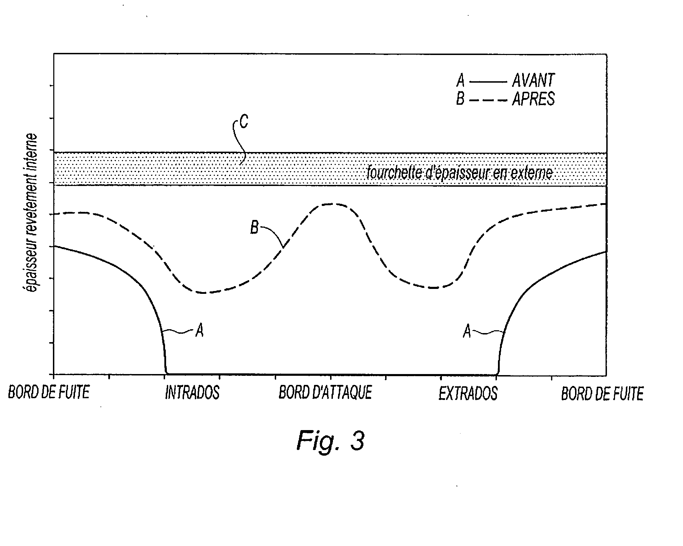

Sur la figure 3 on a représenté sur un graphique, l'épaisseur de la couche d'aluminium formée en surface des parois intérieures des aubes. On constate que, selon la technique antérieure, cette épaisseur A est quasi nulle du côté du bord d'attaque de part et d'autre le long d'une partie de l'intrados et de l'extrados. Selon le procédé on obtient une épaisseur B plus uniforme, par exemple entre 50 et 70µm, aussi bien sur le pourtour de l'aube qu'entre le pied et le sommet de l'aube.

L'épaisseur de la couche interne est à comparer avec celle que l'on trouve après traitement sur la surface externe de la pièce qui est figurée en C sur la figure 3.

## Revendications

1. Procédé d'aluminisation par dépôt en phase vapeur pour la protection contre l'oxydation à haute température d'une pièce métallique de turbomachine,
Ladite pièce (1) comportant une cavité avec une ouverture (5) accessible depuis l'extérieur,
Procédé selon lequel un halogénure est formé par réaction entre un halogène et un donneur métallique contenant de l'aluminium, puis l'halogénure est transporté par un gaz porteur pour venir au contact de ladite pièce métallique,
Ledit donneur métallique étant disposé au moins en partie dans ladite cavité,
**Caractérisé par le fait que** le donneur métallique se présente sous la forme d'un bâtonnet obtenu par frittage à chaud sous pression d'un mélange de poudre métallique.

2. Procédé selon la revendication précédente, le métal composant le bâtonnet comprenant l'aluminium en combinaison avec l'un des métaux Cr, Ni, Co ou Fe.

3. Procédé selon la revendication précédente l'aluminium étant en proportion comprise entre 30 et 80 % atomique dans le bâtonnet.

4. Procédé selon la revendication précédente, l'aluminium étant en proportion comprise entre 45 et 70% atomique.

5. Procédé selon l'une des revendications précédentes dont le bâtonnet comprend également au moins un élément d'amélioration de la tenue à l'oxydation compris dans le groupe suivant (Hf, Y, Zr, Si, Ti, Ta, Pt, Pd, Ir).

6. Procédé selon l'une des revendications précédentes selon lequel la pièce est en superalliage à base nickel ou cobalt

7. Procédé selon la revendication précédente la pièce étant une aube de distributeur avec une chemise intérieure de distribution de fluide de refroidissement dans la cavité, le bâtonnet est introduit par l'ouverture d'amenée de fluide de refroidissement.

## Claims

1. A method of aluminization by deposit in the vapor phase for protection against oxidation at high temperature of a metal part of a turbomachine,
Said part comprising a cavity with an opening that can be accessed from the outside,
A method according to which a halide is formed by reaction between a halogen and a metal donor containing aluminum, then the halide is transported by a carrier gas to come into contact with said metal part,
Said metal donor being placed at least partly in said cavity, Wherein the metal donor is in the form of a rod obtained by hot sintering under pressure of a mixture of metal powder.

2. The method as claimed in the preceding claim, the metal composing the rod comprising aluminum in combination with one of the metals Cr, Ni, Co or Fe.

3. The method as claimed in the preceding claim, the aluminum being in proportion comprised between 30 and 80% atomic in the rod.

4. The method as claimed in the preceding claim, the aluminum being in proportion comprised between 45 and 70% atomic.

5. The method as claimed in claim 1, wherein the rod also comprises at least one element for improving the resistance to oxidation comprised in the following group (Hf, Y, Zr, Si, Ti, Ta, Pt, Pd, Ir).

6. The method as claimed in claim 1, wherein the part is made of a nickel-based or cobalt-based superalloy.

7. The method as claimed in the preceding claim, the part being an upstream guide vane blade with an inner cooling fluid distribution sleeve in the cavity, the rod is inserted through the cooling fluid inlet opening.

## Patentansprüche

1. Verfahren zur Aluminisierung durch Ablage in der Dampfphase zum Schutz gegen die Oxidierung bei hoher Temperatur eines Metallteils eines Turbotriebwerks,
wobei der Teil (1) einen Hohlraum mit einer Öffnung (5) aufweist, die von außen zugänglich ist,
Verfahren, nach dem ein Halogenid durch Reaktion zwischen einem Halogen und einem Metalldonor, umfassend Aluminium, gebildet wird, dann das Halogenid durch ein Trägergas transportiert wird, um mit dem metallischen Teil in Kontakt zu kommen,
wobei der Metalldonor zumindest teilweise in dem Hohlraum angebracht ist,
**dadurch gekennzeichnet, dass** der Metalldonor die Form eines Stäbchens aufweiset, das durch Heißsinterung unter Druck einer metallischen Pulvermischung erhalten wird.

2. Verfahren nach dem vorhergehenden Anspruch, wobei das Metall, das das Stäbchens bildet, Aluminium in Kombination mit einem der Metalle Cr, Ni, Co oder Fe umfasst.

3. Verfahren nach dem vorhergehenden Anspruch, wobei das Aluminium in einem Verhältnis zwischen 30 und 80 Atomprozent im Stäbchen vorhanden ist.

4. Verfahren nach dem vorhergehenden Anspruch, wobei das Aluminium in einem Verhältnis zwischen 45 und 70 Atomprozent im Stäbchen vorhanden ist.

5. Verfahren nach einem der vorhergehenden Ansprüche, wobei das Stäbchen auch zumindest ein Element zur Verbesserung der Oxidierungsbeständigkeit, enthalten in der folgenden Gruppe (Hf, Y, Zr, Si, Ti, Ta, Pt, Pd, Ir), umfasst.

6. Verfahren nach einem der vorhergehenden Ansprüche, wobei der Teil eine Superlegierung auf der Grundlage von Nickel und Kobalt ist.

7. Verfahren nach dem vorhergehenden Anspruch, wobei der Teil08 165 846 eine Leitschaufel mit einem inneren Schaufelmantel aus Kühlfluid im Hohlraum ist, wobei das Stäbchen durch die Einlassöffnung des Kühlfluids eingeführt wird.
